# EUROPEAN PATENT APPLICATION

(11) **EP 3 605 592 A1**
(43) Date of publication of application: **05.02.2020**
(21) Application number: 18775342.1
(22) Date of filing: 26.03.2018
(51) Int. Cl.: H01L 21/337, H01L 21/338, H01L 29/778, H01L 29/808, H01L 29/812

(54) **SEMICONDUCTOR DEVICE**

(30) Priority: 31.03.2017 JP 2017072703
(71) Applicant: Panasonic Intellectual Property Management Co., Ltd., Osaka-shi, Osaka 540-6207 (JP)
(72) Inventor: UENO, Hiroaki, Osaka-shi, Osaka 540-6207 (JP); SUZUKI, Asamira, Osaka-shi, Osaka 540-6207 (JP); ISHIDA, Hidetoshi, Osaka-shi, Osaka 540-6207 (JP)
(74) Representative: Vigand, Philippe
(86) International application number: PCT/JP2018/012186
(87) International publication number: WO 2018/181200

(57) **Abstract**

An object of the present invention is to provide a semiconductor device with the ability to reduce the on-state resistance thereof. A semiconductor portion (3) thereof includes a heterojunction (35) defining a junction between a first compound semiconductor portion (31) and a second compound semiconductor portion (32) having a greater bandgap than the first compound semiconductor portion (31). The heterojunction (35) intersects with a second direction (D2) defined along a first surface (21) of a substrate (2). A first electrode (4) is arranged opposite from the substrate (2) with respect to the semiconductor portion (3). A second electrode (5) is arranged on a second surface (22) of the substrate (2). A gate electrode (6) intersects with the second direction (D2) between the first electrode (4) and the second electrode (5) and faces the second compound semiconductor portion (32). A gate layer (7) is interposed in the second direction (D2) between the gate electrode (6) and the second compound semiconductor portion (32) and forms a depletion layer (8) in the second compound semiconductor portion (32) and the first compound semiconductor portion (31).

## Description

### Technical Field

The present invention generally relates to a semiconductor device, and more particularly relates to a semiconductor device with a heterojunction.

### Background Art

A high electron mobility transistor (HEMT) with a vertical structure has been known as an exemplary semiconductor device (see, for example, Patent Literature 1).

In the HEMT disclosed in Patent Literature 1, a first compound semiconductor layer (GaN layer), a second compound semiconductor layer (AlGaN layer), a third compound semiconductor layer (GaN layer), and a fifth compound semiconductor layer (n⁺-GaN layer) are stacked one on top of another on the surface of a substrate. A fourth compound semiconductor layer (AlGaN layer) is formed on side surfaces of a hole (first hole) formed in this stacked structure. In the first hole, an insulating film with an electrode groove is formed with the fourth compound semiconductor layer interposed. A gate electrode is formed to fill the electrode groove of the insulating film. An interlevel dielectric film is formed on the upper surface of the gate electrode. Thus, the gate electrode is covered with the insulating film and the interlevel dielectric film. Over the gate electrode, a source electrode to be connected to a fifth compound semiconductor layer is formed so as to fill a hole (second hole) cut through the insulating film and the interlevel dielectric film. Under the gate electrode, a drain electrode is formed on the back surface of the substrate.

In this HEMT, 2DEG is generated at the interface between the first, third, and fifth compound semiconductor layers and the fourth compound semiconductor layer. The 2DEG is an electron gas with a high electron density and a high electron mobility. This configuration realizes a vertical HEMT structure which generates an expected 2DEG gas and is able to have a high breakdown voltage and a high output.

As a compound semiconductor for use as a material for the second and fourth compound semiconductor layers, a compound semiconductor that makes the lattice constant of the former equal to or less than the lattice constant of the latter is used. In this case, the 2DEG gas is not generated at the interface between the second compound semiconductor layer and the fourth compound semiconductor layer. This configuration realizes perfect normally off-mode operation.

The semiconductor device disclosed in Patent Literature 1 interposes the second compound semiconductor layer (AlGaN layer) between the first compound semiconductor layer (GaN layer) and the third compound semiconductor layer (GaN layer) to realize the normally off-mode operation, and therefore, has a high on-state resistance.

### Citation List

### Patent Literature

Patent Literature 1: WO 2011/114535 A1

### Summary of Invention

It is therefore an object of the present invention to provide a semiconductor device with the ability to reduce the on-state resistance thereof.

### Solution to Problem

A semiconductor device according to an aspect of the present invention includes a substrate with electrical conductivity, a semiconductor portion, a first electrode, a second electrode, a gate electrode, and a gate layer. The substrate has a first surface and a second surface, which are located opposite from each other in a first direction defining a thickness direction for the substrate. The semiconductor portion is provided on the first surface of the substrate. The semiconductor portion includes a heterojunction defining a junction between a first compound semiconductor portion and a second compound semiconductor portion having a greater bandgap than the first compound semiconductor portion. The heterojunction intersects with a second direction defined along the first surface of the substrate. The first electrode is arranged opposite from the substrate with respect to the semiconductor portion, and is electrically connected to the heterojunction. The second electrode is arranged on the second surface of the substrate and electrically connected to the substrate. The gate electrode intersects with the second direction between the first electrode and the second electrode and faces the second compound semiconductor portion. The gate layer is interposed in the second direction between the gate electrode and the second compound semiconductor portion and forms a depletion layer in the second compound semiconductor portion and the first compound semiconductor portion.

In this semiconductor device, the substrate is suitably a nitride semiconductor substrate. The first surface of the substrate is suitably a crystallographic plane extending along a c-axis. The second direction is defined along the c-axis. Each of the first compound semiconductor portion and the second compound semiconductor portion is suitably a nitride semiconductor.

In this semiconductor device, the gate layer is suitably a p-type semiconductor layer.

In this semiconductor device, the semiconductor portion suitably includes a plurality of the heterojunctions.

In this semiconductor device, the plurality of the heterojunctions suitably extend parallel to each other.

### Brief Description of Drawings

FIG. 1 is a cross-sectional view of a semiconductor device according to an exemplary embodiment of the present invention;
FIG. 2 illustrates how the semiconductor device operates;
FIGS. 3A-3C are cross-sectional views illustrating main process steps of a method for fabricating the semiconductor device;
FIGS. 4A-4C are cross-sectional views illustrating main process steps of the method for fabricating the semiconductor device;
FIGS. 5A-5C are cross-sectional views illustrating main process steps of the method for fabricating the semiconductor device; and
FIGS. 6A and 6B are cross-sectional views illustrating main process steps of the method for fabricating the semiconductor device.

### Description of Embodiments

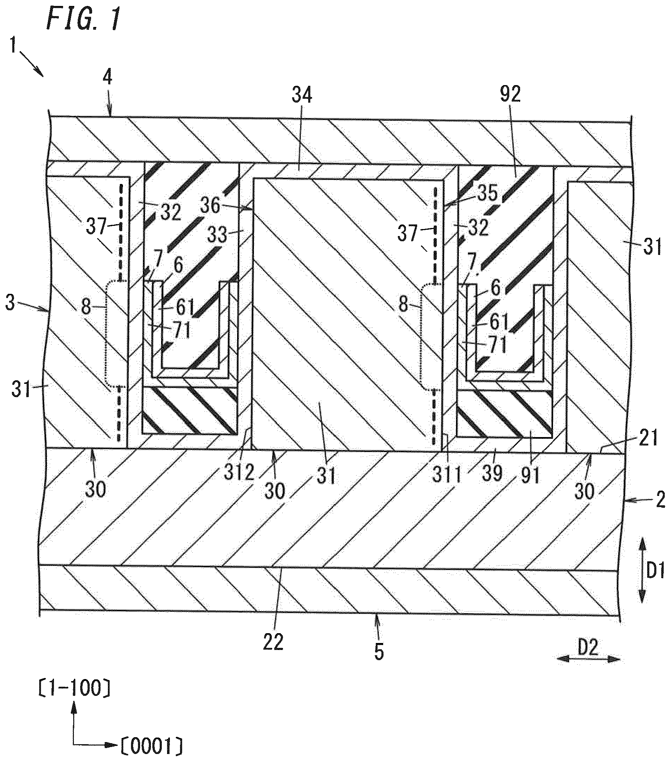

Note that FIGS. 1-6B to be referred to in the following description of exemplary embodiments are just schematic representations, in which the dimensions and thicknesses of respective constituent elements and their ratios are not always to scale, compared with their actual dimensional ratios.

### (Embodiments)

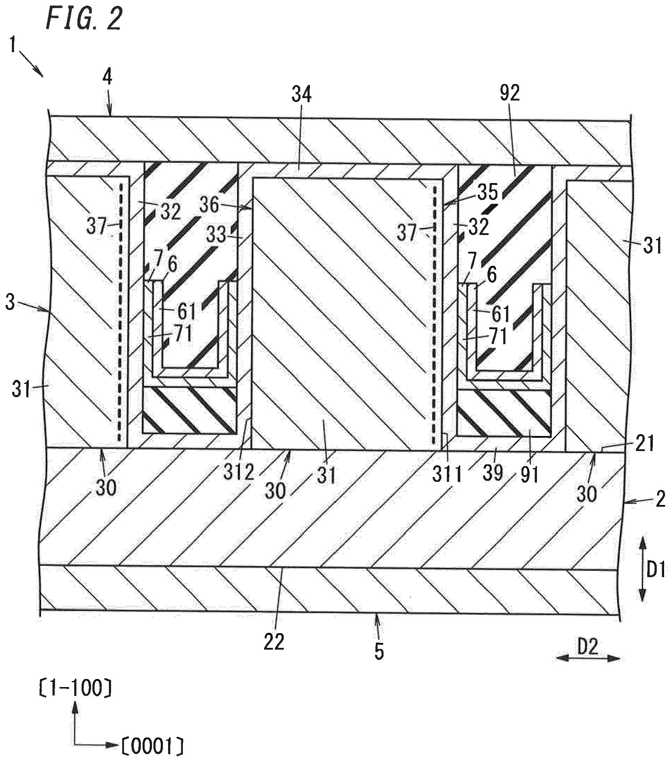

A semiconductor device 1 according to an exemplary embodiment will be described with reference to FIGS. 1 and 2.

The semiconductor device 1 includes a substrate 2 with electrical conductivity, a semiconductor portion 3, a first electrode 4, a second electrode 5, a gate electrode 6, and a gate layer 7. The substrate 2 has a first surface 21 and a second surface 22, which are located opposite from each other in a first direction D1 defining a thickness direction for the substrate 2. The semiconductor portion 3 is provided on the first surface 21 of the substrate 2. The semiconductor portion 3 includes a heterojunction 35 defining a junction between a first compound semiconductor portion 31 and a second compound semiconductor portion 32 having a greater bandgap than the first compound semiconductor portion 31. The heterojunction 35 intersects with a second direction D2 defined along the first surface 21 of the substrate 2. The first electrode 4 is arranged opposite from the substrate 2 with respect to the semiconductor portion 3, and is electrically connected to the heterojunction 35. The second electrode 5 is arranged on the second surface 22 of the substrate 2 and electrically connected to the substrate 2. The gate electrode 6 intersects with the second direction D2 between the first electrode 4 and the second electrode 5 and faces the second compound semiconductor portion 32. The gate layer 7 is interposed in the second direction D2 between the gate electrode 6 and the second compound semiconductor portion 32 and forms a depletion layer 8 in the second compound semiconductor portion 32 and the first compound semiconductor portion 31.

This configuration allows the semiconductor device 1 to reduce the on-state resistance thereof.

A semiconductor device 1 according to this embodiment is implemented as a field effect transistor chip. In the semiconductor device 1 according to this embodiment, the first electrode 4 and the second electrode 5 serve as a source electrode and a drain electrode, respectively. In the following description, the first electrode 4 and the second electrode 5 will be hereinafter referred to as the source electrode 4 and the drain electrode 5, respectively, for the sake of convenience.

Next, respective constituent elements of the semiconductor device 1 will be described in further detail one by one.

The semiconductor device 1 may have a square planar shape, for example. As used herein, the "planar shape of the semiconductor device 1" refers to an outer peripheral shape of the semiconductor device 1 when the semiconductor device 1 is viewed from either side thereof in the first direction D1 defining a thickness direction for the substrate 2. When viewed in plan, the semiconductor device 1 may have a chip size of 1 mm square (1 mm × 1 mm). Note that this numerical value is only an example and should not be construed as limiting. In addition, the semiconductor device 1 does not have to have a square planar shape, either, but may also have a rectangular planar shape as well.

The substrate 2 supports the semiconductor portion 3 thereon. The substrate 2 may be a single crystal GaN substrate, for example. Therefore, the substrate 2 has a hexagonal crystal structure. The second direction D2 is defined along a c-axis of the substrate 2 (which may be parallel to the c-axis of the substrate 2, for example). The c-axis of the substrate 2 points rightward in FIG. 1. At the lower left corner of FIG. 1, shown are a crystallographic axis [0001] indicating the c-axis of the substrate 2 and a crystallographic axis [1-100] indicating the m-axis thereof. The single crystal GaN substrate may be an n-type GaN substrate, for example.

As described above, the substrate 2 has the first surface 21 and the second surface 22, which are located opposite from each other along the thickness of the substrate 2 (i.e., in the first direction D1). In this case, the first surface 21 of the substrate 2 is an m-plane, which may be a (1-100) plane, for example. As used herein, the negative sign "-" added to a Miller index representing a crystallographic plane orientation indicates the inversion of the index following the negative sign. The (1-100) plane is a crystallographic plane represented by four Miller indices enclosed in parentheses.

The first surface 21 of the substrate 2 may be a nonpolar plane defined by the c-axis and does not have to be an m-plane but may be an a-plane as well. The a-plane may be a (1120) plane, for example. Alternatively, the first surface 21 of the substrate 2 may also be a crystallographic plane, of which an off-axis angle with respect to an m-plane (hereinafter referred to as a "first off-axis angle") is greater than 0 degrees and equal to or less than 3 degrees. As used herein, the "first off-axis angle" indicates a tilt angle of the first surface 21 with respect to the m-plane. Thus, if the first off-axis angle is 0 degrees, then the first surface 21 is an m-plane. Likewise, the first surface 21 of the substrate 2 may also be a crystallographic plane, of which an off-axis angle with respect to an a-plane (hereinafter referred to as a "second off-axis angle") is greater than 0 degrees and equal to or less than 3 degrees. As used herein, the "second off-axis angle" indicates a tilt angle of the first surface 21 with respect to the a-plane. Thus, if the second off-axis angle is 0 degrees, then the first surface 21 is an a-plane. The substrate 2 may have a thickness of 100 µm to 700 µm, for example.

The semiconductor portion 3 is provided on the first surface 21 of the substrate 2. The semiconductor portion 3 includes a first compound semiconductor portion 31 and a second compound semiconductor portion 32. In the semiconductor portion 3, the first compound semiconductor portion 31 and the second compound semiconductor portion 32 are arranged side by side in the second direction D2. The semiconductor portion 3 further includes a third compound semiconductor portion 33. The third compound semiconductor portion 33 is arranged opposite, in the second direction D2, from the second compound semiconductor portion 32 with respect to the first compound semiconductor portion 31. Also, in the semiconductor device 1, the first electrode 4 is electrically connected to the heterojunction 35 of the semiconductor portion 3 as described above. As used herein, if one thing is "electrically connected to" another, then it means that these two things make an ohmic contact with each other. In the semiconductor device 1, the first electrode 4 includes an alloy portion 34 that makes an ohmic contact with the heterojunction 35 of the semiconductor portion 3. In this semiconductor device 1, the first electrode 4 contains Ti and Al, and the alloy portion 34 contains Al, Ti, and Ga, for example. The alloy portion 34 is interposed between the first compound semiconductor portion 31 and the first electrode 4 so as to be located between two ends, adjacent in the second direction D2 to the alloy portion 34, of the second and third compound semiconductor portions 32 and 33, namely, between one end, adjacent to the first electrode 4, of the second compound semiconductor portion 32 and one end, adjacent to the first electrode 4, of the third compound semiconductor portion 33. The semiconductor portion 3 further includes a fourth compound semiconductor portion 39. The fourth compound semiconductor portion 39 is also located between two ends, adjacent in the second direction D2 to the alloy portion 34, of the second and third compound semiconductor portions 32 and 33, namely, between one end, adjacent to the substrate 2, of the second compound semiconductor portion 32 and one end, adjacent to the substrate 2, of the third compound semiconductor portion 33.

In the semiconductor portion 3, the respective bandgap energies of the second compound semiconductor portion 32, the third compound semiconductor portion 33, and the fourth compound semiconductor portion 39 are greater than the bandgap energy of the first compound semiconductor portion 31. Also, in the semiconductor portion 3, as measured in the second direction D2, the thicknesses of the second compound semiconductor portion 32 and the third compound semiconductor portion 33 are each less than that of the first compound semiconductor portion 31. Furthermore, in this semiconductor portion 3, as measured along the thickness of the substrate 2 (i.e., in the first direction D1), the thickness of the fourth compound semiconductor portion 39 is less than that of the first compound semiconductor portion 31.

When measured along the thickness of the substrate 2 (i.e., as measured in the first direction D1), the thickness of the first compound semiconductor portion 31 may be 10 µm, for example. Note that this numerical value is only an example and should not be construed as limiting. Alternatively, the first compound semiconductor portion 31 may also have a thickness falling within the range from about 5 µm to about 25 µm, for example. When measured in the second direction D2, the thickness of the first compound semiconductor portion 31 may be 8 µm, for example. When measured in the second direction D2, the respective thicknesses of the second compound semiconductor portion 32 and the third compound semiconductor portion 33 may each be 20 nm. As measured along the thickness of the substrate 2 (as measured in the first direction D1), the thickness of the fourth compound semiconductor portion 39 may be 20 nm, for example.

Each of the first compound semiconductor portion 31, the second compound semiconductor portion 32, the third compound semiconductor portion 33, and the fourth compound semiconductor portion 39 may be a Group III-V compound semiconductor (e.g., a nitride semiconductor in this example). More specifically, the first compound semiconductor portion 31 may be made up of undoped GaN crystals. Each of the second compound semiconductor portion 32, the third compound semiconductor portion 33, and the fourth compound semiconductor portion 39 may be made up of undoped AlGaN crystals. In the semiconductor portion 3, the second compound semiconductor portion 32, the third compound semiconductor portion 33, and the fourth compound semiconductor portion 39 have the same composition ratio. However, this is only an example and should not be construed as limiting. Alternatively, the second, third, and fourth compound semiconductor portions 32, 33, and 39 may have different composition ratios. In this specification, the composition ratio may be a value obtained by composition analysis according to energy dispersive X-ray spectroscopy (EDX). When their magnitudes are discussed, the composition ratios do not have to be values obtained by the EDX but may also be values obtained by composition analysis according to Auger electron spectroscopy.

The semiconductor portion 3 has the heterojunction 35 defining a junction between the first compound semiconductor portion 31 and the second compound semiconductor portion 32 (hereinafter referred to as a "first heterojunction 35"). The first heterojunction 35 intersects (e.g., at right angles in this embodiment) with the second direction D2 defined along the first surface 21 of the substrate 2. The semiconductor portion 3 also has the heterojunction 36 defining a junction between the first compound semiconductor portion 31 and the third compound semiconductor portion 33 (hereinafter referred to as a "second heterojunction 36"). The second heterojunction 36 intersects (e.g., at right angles in this embodiment) with the second direction D2 defined along the first surface 21 of the substrate 2. However, the first heterojunction 35 and the second heterojunction 36 do not always intersect at right angles with the second direction D2 (i.e., the angle formed between each of the first heterojunction 35 and the second heterojunction 36 and the second direction D2 is not always 90 degrees). Alternatively, the angle formed between each of the first heterojunction 35 and the second heterojunction 36 and the second direction D2 may fall within the range from 80 degrees to 100 degrees.

The first compound semiconductor portion 31 is formed directly on the first surface 21 of the substrate 2. The first compound semiconductor portion 31 has a first surface 311 and a second surface 312, which are located opposite from each other in the second direction D2. The first surface 311 is a Group III polar plane (a Ga polar plane in this embodiment) of the first compound semiconductor portion 31. The Ga polar plane (+c plane) is a (0001) plane. The first surface 311 does not have to be a Group III polar plane but may also be a crystallographic plane forming a tilt angle of 1 to 10 degrees with respect to the Group III polar plane. The second surface 312 is a Group V polar plane (an N polar plane in this embodiment) of the first compound semiconductor portion 31. The N polar plane (-c plane) is a (000-1) plane. The second surface 312 does not have to be a Group V polar plane but may also be a crystallographic plane forming a tilt angle of 1 to 10 degrees with respect to the Group V polar plane.

In the semiconductor portion 3, the first heterojunction 35 is formed to include the first surface 311 of the first compound semiconductor portion 31. In addition, in the semiconductor portion 3, the second heterojunction 36 is formed to include the second surface 312 of the first compound semiconductor portion 31.

In the semiconductor portion 3, in the vicinity of the first heterojunction 35 intersecting with the second direction D2, a two-dimensional electron gas 37 has been generated by spontaneous polarization and piezoelectric polarization of a nitride semiconductor (e.g., undoped AlGaN crystals that form the second compound semiconductor portion 32). In other words, in the semiconductor portion 3, the first heterojunction 35 generates the two-dimensional electron gas 37. A region including the two-dimensional electron gas 37 (hereinafter referred to as a "two-dimensional electron gas layer") may function as an n-channel layer (electron conduction layer). In addition, in the semiconductor portion 3, in the vicinity of the second heterojunction 36 intersecting with the second direction D2, a two-dimensional hole gas has been generated by spontaneous polarization and piezoelectric polarization of a nitride semiconductor (e.g., undoped AlGaN crystals that form the third compound semiconductor portion 33). In other words, in the semiconductor portion 3, the second heterojunction 36 generates the two-dimensional hole gas. A region including the two-dimensional hole gas (hereinafter referred to as a "two-dimensional hole gas layer") may function as a p-channel layer (hole conduction layer). In this semiconductor device 1, the alloy portion 34 of the first electrode 4 is electrically connected to the two-dimensional electron gas layer and the two-dimensional hole gas layer.

The semiconductor portion 3 suitably includes a plurality of (e.g., 1,000) double heterostructures 30, which are arranged side by side in the second direction D2 so as to be separated from each other. In each of the double heterostructures 30, the third compound semiconductor portion 33, the first compound semiconductor portion 31, and the second compound semiconductor portion 32 are arranged in this order in the second direction D2. That is to say, the semiconductor portion 3 includes a plurality of first compound semiconductor portions 31, a plurality of second compound semiconductor portions 32, and a plurality of third compound semiconductor portions 33.

Each of the plurality of double heterostructures 30 has the first heterojunction 35 and the second heterojunction 36. Thus, the semiconductor portion 3 includes a plurality of (e.g., 1,000) first heterojunctions 35 and a plurality of (e.g., 1,000) second heterojunctions 36. In this embodiment, in the semiconductor portion 3, the plurality of first heterojunctions 35 extend parallel to each other, and the plurality of second heterojunctions 36 also extend parallel to each other. In this semiconductor device 1, the plurality of first heterojunctions 35 are arranged in the second direction D2 at generally regular intervals. Also, in this semiconductor device 1, the interval between two first heterojunctions 35 adjacent to each other in the second direction D2 may be 10 µm, for example. Furthermore, in this semiconductor device 1, the interval between two second heterojunctions 36 adjacent to each other in the second direction D2 may also be 10 µm, for example.

The semiconductor portion 3 may be formed by, for example, epitaxial growth, photolithography, and etching techniques.

The first compound semiconductor portion 31 may be formed by epitaxial growth, for example. In that case, the epitaxial growth may be a metalorganic vapor phase epitaxy (MOVPE), for example. However, this is only an example and should not be construed as limiting. The epitaxial growth does not have to be the MOVPE but may also be hydride vapor phase epitaxy (HVPE) or molecular beam epitaxy (MBE), for example. The second compound semiconductor portion 32, the third compound semiconductor portion 33, and the fourth compound semiconductor portion 39 may also be formed by epitaxial growth, for example. In that case, the epitaxial growth is suitably the MOVPE. The undoped GaN crystals and the undoped AlGaN crystals may include Mg, H, Si, C, O, and other impurities to be inevitably contained during their growth.

The semiconductor device 1 includes the first electrode 4 (source electrode 4), the second electrode 5 (drain electrode 5), and the gate electrode 6 as described above. In this semiconductor device 1, the first electrode 4 and the second electrode 5 face each other with the semiconductor portion 3 and the substrate 2 interposed between themselves. In addition, in this semiconductor device 1, the first electrode 4 and the second electrode 5 are separated from each other in the first direction D1 (i.e., along the thickness of the substrate 2). Furthermore, in this semiconductor device 1, the gate electrode 6 is located between, and separated from, the first electrode 4 and the second electrode 5. Furthermore, in this semiconductor device 1, the gate layer 7 is interposed in the second direction D2 between the gate electrode 6 and the double heterostructure 30.

The first electrode 4 is arranged opposite from the substrate 2 with respect to the semiconductor portion 3, and is electrically connected to the heterojunction 35. In this embodiment, the first electrode 4 is formed to make an ohmic contact with each of the plurality of first heterojunctions 35 and each of the plurality of second heterojunctions 36. Thus, the first electrode 4 includes the alloy portion 34 described above.

The second electrode 5 is arranged on, and electrically connected to, the second surface 22 of the substrate 2. In this embodiment, the second electrode 5 is formed to make an ohmic contact with the substrate 2. More specifically, the second electrode 5 may be formed by forming a metal layer on the second surface 22 of the substrate 2 and then sintering the metal layer.

The gate layer 7 is interposed in the second direction D2 between the gate electrode 6 and the semiconductor portion 3. More specifically, the gate layer 7 is interposed in the second direction D2 between the gate electrode 6 and the second compound semiconductor portion 32. The gate layer 7 forms a depletion layer 8 in the second compound semiconductor portion 32 and the first compound semiconductor portion 31. The gate layer 7 forms the depletion layer 8 in the semiconductor portion 3 when no voltage is applied between the gate electrode 6 and the source electrode 4 or between the drain electrode 5 and the source electrode 4. This allows the semiconductor device 1 to operate as a normally off-mode field effect transistor without providing any AlGaN layer for a current path between the first electrode 4 and the second electrode 5. In this semiconductor device 1, a voltage that turns the semiconductor device 1 on is applied between the gate electrode 6 and the source electrode 4. When a voltage is applied between the drain electrode 5 and the source electrode 4, the semiconductor portion 3 between the source electrode 4 and the substrate 2 may be linked with the two-dimensional electron gas 37 (see FIG. 2). In other words, in this semiconductor device 1, the two-dimensional electron gas 37 is not interrupted by the depletion layer 8 halfway between the source electrode 4 and the substrate 2.

The gate layer 7 may be a p-type semiconductor layer, for example. In this embodiment, the p-type semiconductor layer may be a metal oxide layer, for example. The metal oxide layer functioning as a p-type semiconductor layer may be an NiO layer, for example. Optionally, the NiO layer may contain, as an impurity, at least one alkali metal selected from the group consisting of lithium (Li), sodium (Na), potassium (K), rubidium (Rb), and cesium (Cs). The NiO layer may also contain a transition metal such as silver (Ag) or copper (Cu) which becomes univalent when added as an impurity. When measured in the second direction D2, the thickness of the gate layer 7 may be 100 nm, for example.

The gate layer 7 is separated in the first direction D1 from the first electrode 4 and the second electrode 5. In the semiconductor device 1 according to this embodiment, the distance as measured in the first direction D1 from the gate layer 7 to the source electrode 4 is shorter than the distance as measured in the first direction D1 from the gate layer 7 to the drain electrode 5. When taken along a plane perpendicular to the first direction D1, the gate layer 7 has a comb shape having a plurality of comb teeth portions 71 and a comb base portion. The plurality of comb teeth portions 71 are arranged between two double heterostructures, which are adjacent to each other in the second direction D2. When taken along a plane including the first direction D1 and the second direction D2, each of the plurality of comb teeth portions 71 of the gate layer 7 has a U-shaped cross section. Thus, the gate layer 7 is also interposed in the second direction D2 between the gate electrode 6 and the third compound semiconductor portion 33.

The semiconductor device 1 further includes a first insulating layer 91 interposed in the first direction D1 between the gate layer 7 and the fourth compound semiconductor portion 39 on the first surface 21 of the substrate 2. The first insulating layer 91 has electrical insulation properties. The first insulating layer 91 may be made of silicon nitride, for example, but may also be made of silicon dioxide, for example.

The gate electrode 6 is formed, in the second direction, on the gate layer 7. In short, the gate electrode 6 is formed along the surface of the gate layer 7 in the first direction D1. When taken along a plane perpendicular to the second direction D2, the gate electrode 6 is formed along the surface of the semiconductor portion 3 with the gate layer 7 interposed. When taken along a plane perpendicular to the first direction D1, the gate electrode 6 has a comb shape having a plurality of comb teeth portions 61 and a comb base portion. The plurality of comb teeth portions 61 are arranged between two double heterostructures 30, which are adjacent to each other in the second direction D2. When taken along a plane including the first direction D1 and the second direction D2, each of the plurality of comb teeth portions 61 of the gate electrode 6 has a U-shaped cross section. In this embodiment, the gate electrode 6 makes an ohmic contact with the gate layer 7. However, this is only an example and should not be construed as limiting. If the gate layer 7 is implemented as a metal oxide layer, for example, the gate electrode 6 does not necessarily make an ohmic contact with the gate layer 7.

In this semiconductor device 1, a second insulating layer 92 is interposed along the thickness D1 of the substrate 2 between the source electrode 4 and the gate electrode 6 to electrically insulate the source electrode 4 and the gate electrode 6 from each other. The second insulating layer 92 has electrical insulation properties. In this embodiment, the second insulating layer 92 is made of silicon nitride. However, this is only an example and should not be construed as limiting. Alternatively, the second insulating layer 92 may also be made of silicon dioxide, for example.

The semiconductor device 1 according to the embodiment described above includes a substrate 2 with electrical conductivity, a semiconductor portion 3, a first electrode 4, and a second electrode 5. The substrate 2 has a first surface 21 and a second surface 22, which are located opposite from each other in a first direction D1 defining a thickness direction for the substrate 2. The semiconductor portion 3 is provided on the first surface 21 of the substrate 2. The semiconductor portion 3 includes a heterojunction 35 defining a junction between a first compound semiconductor portion 31 and a second compound semiconductor portion 32 having a greater bandgap than the first compound semiconductor portion 31. The heterojunction 35 intersects with a second direction D2 defined along the first surface 21 of the substrate 2. The first electrode 4 is arranged opposite from the substrate 2 with respect to the semiconductor portion 3, and is electrically connected to the heterojunction 35. The second electrode 5 is arranged on the second surface 22 of the substrate 2 and electrically connected to the substrate 2. The gate electrode 6 intersects with the second direction D2 between the first electrode 4 and the second electrode 5 and faces the second compound semiconductor portion 32. The gate layer 7 is interposed in the second direction D2 between the gate electrode 6 and the second compound semiconductor portion 32. In the semiconductor device 1, the substrate 2 is a nitride semiconductor substrate. The first surface 21 of the substrate 2 is a crystallographic plane extending along a c-axis. In the semiconductor device 1, each of the first compound semiconductor portion 31 and the second compound semiconductor portion 32 is suitably a nitride semiconductor. The gate layer 7 is a p-type semiconductor layer.

This configuration allows the semiconductor device 1 to be used as a normally off-mode field effect transistor and reduce the on-state resistance thereof. This allows the semiconductor device 1 to reduce the on-state resistance thereof while increasing its breakdown voltage.

In this semiconductor device 1, the larger the number of the first heterojunctions 35 is, the easier it is for the semiconductor device 1 to reduce its on-state resistance. Thus, increasing the number of the first heterojunctions 35 by shortening the distance between the first heterojunctions 35 that are adjacent to each other in the second direction D2 allows the semiconductor device 1 to reduce RonA (which is on-state resistance per unit area and of which the unit may be Ω·cm², for example). As used herein, RonA is the product of Ron (which is the on-state resistance and of which the unit is Ω) and the area of the semiconductor device 1 (which is the chip area of the semiconductor device 1 in a plan view and may be 1 cm × 1 cm = 1 cm², for example).

In addition, in this semiconductor device 1, the greater the length of the first heterojunctions 35 as measured perpendicularly to the first direction D1 and the second direction D2 is, the easier it is for the semiconductor device 1 to reduce its resistance RonA.

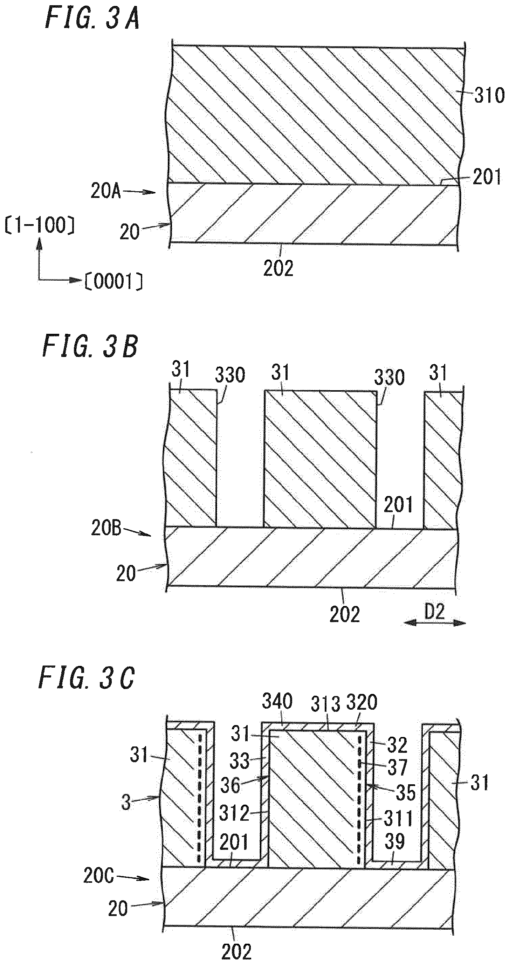

Next, an exemplary method for fabricating the semiconductor device 1 will be briefly described with reference to FIGS. 3A-6B.

According to this method for fabricating the semiconductor device 1, first, a wafer 20 (see FIG. 3A), which will be respective substrates 2 for a plurality of semiconductor devices 1, is provided. The wafer 20 may be a GaN wafer, for example. The wafer 20 has a first surface 201 and a second surface 202, which are located opposite from each other along the thickness thereof.

According to this method for fabricating the semiconductor device 1, after the wafer 20 has been provided, the following first through eleventh process steps are performed sequentially.

In the first process step, the wafer 20 is subjected to pretreatment, loaded into an epitaxial growth system, and then a first compound semiconductor layer 310 (e.g., an undoped GaN layer in this example) as a prototype of first compound semiconductor portions 31 is stacked by epitaxial growth process (i.e., epitaxially grown) on the first surface 201 of the wafer 20 (see FIG. 3A). The first surface 201 of the wafer 20 is a surface corresponding to the first surface 21 of the substrate 2. If an MOVPE system is adopted as the epitaxial growth system, trimethylgallium (TMGa) is suitably used as a Ga source gas and NH₃ is suitably used as an N source gas. A carrier gas for the respective source gases is suitably an H₂ gas, an N₂ gas, or a mixture of an H₂ gas and an N₂ gas, for example. As for conditions for growing the first compound semiconductor layer 310, substrate temperature, V/III ratio, flow rates of the respective source gases, growth pressures, and other parameters may be set appropriately. The "substrate temperature" refers herein to the temperature of the wafer. When an MOVPE system is used as an epitaxial growth system, the "substrate temperature" may be replaced with the temperature of a susceptor supporting the wafer 20. For example, the substrate temperature may be replaced with the temperature of the susceptor measured with a thermocouple. The "V/III ratio" refers herein to the ratio of the molar flow rate [µmol/min] of a source gas of a Group V element to the molar flow rate [µmol/min] of a source gas of a Group III element. The "growth pressure" refers herein to the pressure in the reaction furnace in a state where the respective source gases and carrier gases are being supplied into the reaction furnace of the MOVPE system.

In the first process step, a wafer 20A, including the wafer 20 and the first compound semiconductor layer 310, is unloaded from the epitaxial growth system.

In the second process step, the first compound semiconductor layer 310 is patterned by photolithography and etching techniques to form first compound semiconductor portions 31 (see FIG. 3B). More specifically, in the second process step, a plurality of trenches 330 are formed from the surface of the first compound semiconductor layer 310 of the wafer 20A to obtain a wafer 20B including the wafer 20 and a plurality of first compound semiconductor portions 31. The plurality of trenches 330 are arranged side by side in the second direction D2. The depth of the trenches 330 may be equal to, for example, the designed length of the first compound semiconductor portions 31 as measured along the thickness of the substrate 2 that corresponds to the first direction D1. An etching system for use in the process step of forming the plurality of trenches 330 may be an inductively coupled plasma (ICP) dry etching system, for example. As an etch gas, a Cl₂ gas, an SF₆ gas, or any other suitable gas may be used, for example.

In the third process step, the wafer 20B is loaded into an epitaxial growth system, and then a second compound semiconductor layer 320 (e.g., an undoped AlGaN layer in this example) is stacked by epitaxial growth process (i.e., epitaxially grown) on the wafer 20B to cover the plurality of first compound semiconductor portions 31 (see FIG. 3C). In this manner, a wafer 20C, including the wafer 20, the plurality of first compound semiconductor portions 31, and the second compound semiconductor layer 320, is obtained. The second compound semiconductor layer 320 includes a second compound semiconductor portion 32 formed on the first surface 311 of each of the first compound semiconductor portions 31, a third compound semiconductor portion 33 formed on the second surface 312 of each of the first compound semiconductor portions 31, and a fourth compound semiconductor portion 39 formed on the first surface 21 of the substrate 2. Thus, in this wafer 20C, a semiconductor portion 3 has been formed on the wafer 20. The second compound semiconductor layer 320 further includes a fifth compound semiconductor portion 340 as a prototype of an alloy portion 34. The fifth compound semiconductor portion 340 is formed on the third surface 313, which is located opposite from the substrate 2 with respect to the first compound semiconductor portions 31. If an MOVPE system is adopted as the epitaxial growth system, trimethylaluminum (TMA1) may be used as an Al source gas, trimethylgallium (TMGa) may be used as a Ga source gas, and NH₃ may be used as an N source gas, for example. A carrier gas for the respective source gases may be an H₂ gas, an N₂ gas, or a mixture of an H₂ gas and an N₂ gas, for example. In the third process step, the wafer 20C, including the second compound semiconductor layer 320, is unloaded from the epitaxial growth system.

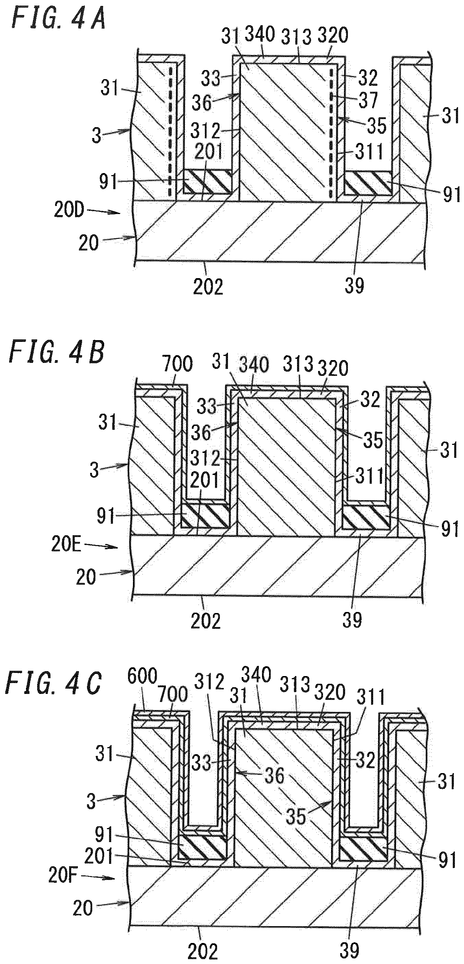

In the fourth process step, a first insulating layer 91 is formed on the fourth compound semiconductor portion 39 (see FIG. 4A). More specifically, in the fourth process step, a first insulating film as a prototype of the first insulating layer 91 is formed by chemical vapor deposition (CVD), for example, to cover the second compound semiconductor layer 320 and then etched back to form the first insulating layer 91 out of a part of the first insulating film. In this manner, a wafer 20D, including the wafer 20 and the semiconductor portion 3, is obtained as a result of the fourth process step. In this example, the first insulating film is a silicon nitride film. However, this is only an example and should not be construed as limiting. Alternatively, the first insulating film may also be a silicon dioxide film, for example.

In the fifth process step, a p-type semiconductor film 700 as a prototype of a gate layer 7 is formed to cover the second compound semiconductor portions 32, the third compound semiconductor portions 33, the fourth compound semiconductor portions 39, the fifth compound semiconductor portions 340, and the first insulating layer 91 (see FIG. 4B). In this manner, a wafer 20E, including the wafer 20, the semiconductor portion 3, and the p-type semiconductor film 700, is obtained as a result of the fifth process step. If the gate layer 7 is an NiO layer, the p-type semiconductor film 700 may be formed by atomic layer deposition (ALD) process, for example, in this fifth process step.

In the sixth process step, a gate electrode layer 600 as a prototype of a gate electrode 6 is formed on the p-type semiconductor film 700 (see FIG. 4C). In this example, in the sixth process step, either a stack of a Pd film and an Au film or a stack of an Ni film and an Au film is formed by evaporation process, for example, as a prototype film of the gate electrode 6, and then subjected to sintering process, which is a heat treatment for causing the stack to be patterned into the gate electrode 6 to make an ohmic contact with the p-type semiconductor film 700, thereby forming a gate electrode layer 600 that makes an ohmic contact with the p-type semiconductor film 700. In this manner, a wafer 20F, including the wafer 20, the semiconductor portion 3, the p-type semiconductor film 700, and the gate electrode layer 600, is obtained as a result of the sixth process step.

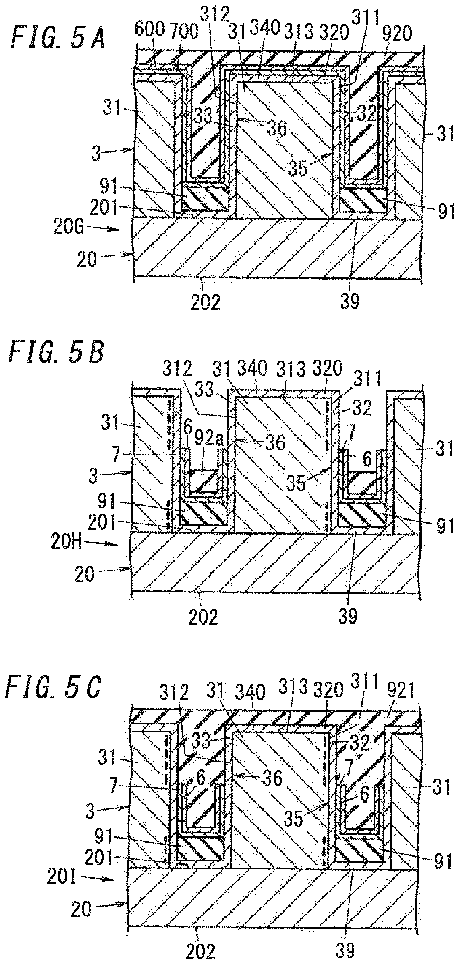

In the seventh process step, a second insulating film 920 to be patterned into a part 92a of a second insulating layer 92 (see FIG. 5B) is formed by CVD process, for example, to cover the gate electrode layer 600 (see FIG. 5A). In this manner, a wafer 20G, including the wafer 20, the semiconductor portion 3, the p-type semiconductor film 700, the gate electrode layer 600, and the second insulating film 920, is obtained as a result of the seventh process step. In this example, the second insulating film 920 is a silicon nitride film. However, this is only an example and should not be construed as limiting. Alternatively, the second insulating film 920 may also be a silicon dioxide film, for example.

In the eighth process step, the second insulating film 920, the gate electrode layer 600, and the p-type semiconductor film 700 are etched back to form a gate layer 7, gate electrodes 6, and parts 92a of the second insulating layer 92 (see FIG. 5B). In this manner, a wafer 20H, including the wafer 20, the semiconductor portion 3, the gate layer 7, the gate electrodes 6, and the parts 92a of the second insulating layer 92, is obtained as a result of the eighth process step.

In the ninth process step, a third insulating film 921 as a prototype of the rest of the second insulating layer 92 other than the parts 92a is formed by CVD process, for example (see FIG. 5C). In this manner, a wafer 201, including the wafer 20, the semiconductor portion 3, the first insulating layer 91, the gate layer 7, the gate electrode 6, and the third insulating film 921, is obtained as a result of the ninth process step. In this example, the third insulating film 921 is a silicon nitride film. However, this is only an example and should not be construed as limiting. Alternatively, the third insulating film 921 may also be a silicon dioxide film, for example.

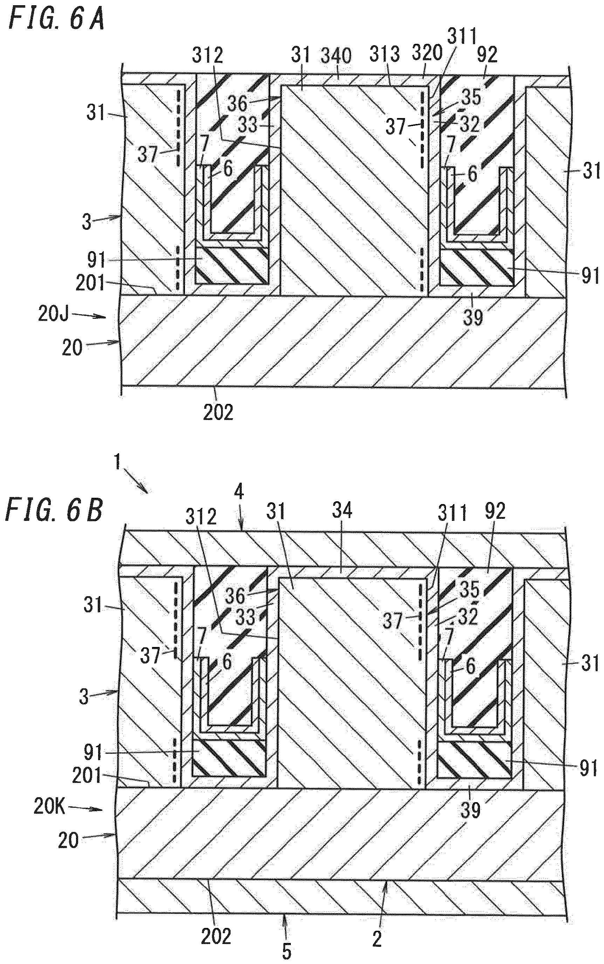

In the tenth process step, the third insulating film 921 is etched back to form a second insulating layer 92 (see FIG. 6A). In this manner, a wafer 20J, including the wafer 20, the semiconductor portion 3, the first insulating layer 91, the gate layer 7, the gate electrodes 6, and the second insulating layer 92, is obtained as a result of the tenth process step.

In the eleventh process step, a first electrode 4 and a second electrode 5 are formed (see FIG. 6B). More specifically, a first metal layer and a second metal layer, each having a predetermined pattern to define the first electrode 4 or the second electrode 5, is formed by thin film deposition technique, for example, and then subjected to a sintering process which is a heat treatment to make an ohmic contact. In this manner, a first electrode 4 electrically connected to the first heterojunctions 35 and the second heterojunctions 36 and a second electrode 5 electrically connected to the substrate 2 are formed as a result of the eleventh process step. In the eleventh process step, the metal in the first metal layer diffuses to enter the fifth compound semiconductor portions 340, thus forming alloy portions 34. In this manner, a wafer 20K, including the wafer 20, the semiconductor portion 3, the first electrode 4, and the second electrode 5, is obtained as a result of the eleventh process step. At this time, a plurality of semiconductor devices 1 have been formed on the wafer 20K. That is to say, according to this method for fabricating the semiconductor device 1, such a wafer 20K with the plurality of semiconductor devices 1 is obtained by performing the first through eleventh process steps. Optionally, according to this method for fabricating the semiconductor device 1, before the second electrode 5 is formed, the wafer 20 may be polished from the second surface 202, opposite from the first surface 201, to make the thickness of the wafer 20 equal to a desired thickness of the substrate 2.

Finally, according to this method for fabricating the semiconductor device 1, the wafer 20K is cut with a dicing saw, for example, to divide the single wafer 20K into a plurality of semiconductor devices 1.

Note that the embodiment described above is only an exemplary one of various embodiments of the present invention and should not be construed as limiting. Rather, the embodiment described above may be readily modified in various other manners, depending on a design choice or any other factor, without departing from a scope of the present invention.

For example, in a first variation of the semiconductor device 1, generation of a hole-electron gas in the vicinity of the second heterojunction 36 may be reduced by setting the angle formed between a plane perpendicular to the second direction D2 and the second heterojunction 36 at a value greater than 10 degrees. In that case, the second surface 312 of the first compound semiconductor portion 31 is a tilted surface which forms a tilt angle larger than 10 degrees with respect to the plane perpendicular to the second direction D2. Such a tilted surface may be formed by photolithography and etching techniques using a grayscale mask, for example, while the first compound semiconductor layer 310 is patterned in the second process step described above.

A second variation of the semiconductor device 1 includes neither the gate electrode 6 nor the gate layer 7 of the semiconductor device 1 according to the embodiment described above. In the second variation, a plurality of double heterostructures 30 are arranged side by side in the second direction D2 as in the semiconductor device 1 according to the embodiment described above, and therefore, undoped AlGaN crystals and undoped GaN crystals are arranged alternately in the second direction D2. Thus, in the second variation, a plurality of two-dimensional electron gas layers and a plurality of two-dimensional hole gas layers are arranged alternately in the second direction D2 with respect to the semiconductor portion 3. Also, in the second variation, one of the first electrode 4 or the second electrode 5 constitutes an anode electrode while the other constitutes a cathode electrode. In the second variation, one of the first electrode 4 or the second electrode 5 which has the higher potential than the other when a voltage is applied between the first electrode 4 and the second electrode 5 constitutes an anode electrode, while the other electrode with the lower potential than the other constitutes a cathode electrode. The second variation is a multi-channel diode.

More specifically, in the second variation of the semiconductor device 1, in each of the plurality of double heterostructures 30, the third compound semiconductor portion 33, the first compound semiconductor portion 31, and the second compound semiconductor portion 32 are arranged in this order in the second direction D2. Each of the plurality of double heterostructures 30 includes the first heterojunction 35, which is the heterojunction 35 between the first compound semiconductor portion 31 and the second compound semiconductor portion 32, and the second heterojunction 36, which is a heterojunction 36 between the first compound semiconductor portion 31 and the third compound semiconductor portion 33. In the second variation of the semiconductor device 1, one of the first electrode 4 or the second electrode 5 constitutes an anode electrode, while the other constitutes a cathode electrode. Thus, the second variation of the semiconductor device 1 provides a diode with the ability to reduce its resistance while increasing its breakdown voltage.

Also, in the semiconductor device 1 described above, the first electrode 4 and the second electrode 5 constitute a source electrode and a drain electrode, respectively. However, this is only an example and should not be construed as limiting. Alternatively, the first electrode 4 and the second electrode 5 may constitute a drain electrode and a source electrode, respectively.

Furthermore, the substrate 2 only needs to be a single crystal substrate with electrical conductivity, and does not have to be a GaN substrate. Alternatively, the substrate 2 may also be an AlN substrate, for example.

Furthermore, the plurality of double heterostructures 30 do not have to be arranged at regular intervals.

Furthermore, the gate layer 7 only needs to form the depletion layer 8 such that the depletion layer 8 goes beyond the first heterojunction 35 from the interface between the second compound semiconductor portion 32 and the gate layer 7. In addition, the gate layer 7 only needs to form the depletion layer 8 such that the depletion layer 8 goes beyond the second heterojunction 36 from the interface between the third compound semiconductor portion 33 and the gate layer 7. Therefore, the gate layer 7 has only to be a p-type semiconductor layer and does not have to be an NiO layer. Alternatively, the gate layer 7 may also be a p-type AlGaN layer or a p-type GaN layer, for example. The p-type AlGaN layer and the p-type GaN layer each have been doped with Mg during their growth and contain Mg. The p-type semiconductor forming the p-type semiconductor layer is suitably a p-type metal oxide or a p-type Group III-V compound semiconductor, for example, each having a greater bandgap than GaN. If a p-type AlGaN layer is adopted as the gate layer 7, the gate electrode 6 needs to make an ohmic contact with the gate layer 7.

Optionally, in the semiconductor device 1, an AlGaN layer with a thickness less than 1 nm (e.g., about 0.5 nm) may be provided in the middle of the thickness of the first compound semiconductor portion 31.

Furthermore, in the semiconductor portion 3, the heterojunction 35 between the first compound semiconductor portion 31 and the second compound semiconductor portion 32 only needs to give off the two-dimensional electron gas 37, and the first compound semiconductor portion 31, the second compound semiconductor portion 32, the third compound semiconductor portion 33, and the fourth compound semiconductor portion 39 do not have to be a nitride semiconductor but may also be any other Group III-V compound semiconductor. For example, in the semiconductor device 1, the first compound semiconductor portion 31 may be made of undoped GaAs crystals, and the second compound semiconductor portion 32, the third compound semiconductor portion 33, and the fourth compound semiconductor portion 39 may be made of Si-doped AlGaAs crystals. In that case, the substrate 2 may be an n-type GaAs substrate.

### (Resume)

The following aspects are disclosed from the exemplary embodiment and its variations described above.

A semiconductor device (1) according to a first aspect includes a substrate (2) with electrical conductivity, a semiconductor portion (3), a first electrode (4), a second electrode (5), a gate electrode (6), and a gate layer (7). The substrate (2) has a first surface (21) and a second surface (22), which are located opposite from each other in a first direction (D1) defining a thickness direction for the substrate (2). The semiconductor portion (3) is provided on the first surface (21) of the substrate (2). The semiconductor portion (3) includes a heterojunction (35) defining a junction between a first compound semiconductor portion (31) and a second compound semiconductor portion (32) having a greater bandgap than the first compound semiconductor portion (31). The heterojunction (35) intersects with a second direction (D2) defined along the first surface (21) of the substrate (2). The first electrode (4) is arranged opposite from the substrate (2) with respect to the semiconductor portion (3), and is electrically connected to the heterojunction (35). The second electrode (5) is arranged on the second surface (22) of the substrate (2) and electrically connected to the substrate (2). The gate electrode (6) intersects with the second direction (D2) between the first electrode (4) and the second electrode (5) and faces the second compound semiconductor portion (32). The gate layer (7) is interposed in the second direction (D2) between the gate electrode (6) and the second compound semiconductor portion (32) and forms a depletion layer (8) in the second compound semiconductor portion (32) and the first compound semiconductor portion (31).

This configuration allows the semiconductor device (1) to perform normally off-mode operation and reduce the on-state resistance thereof. Thus, the semiconductor device (1) is able to cut down the loss while performing the normally off-mode operation.

In a semiconductor device (1) according to a second aspect, which may be implemented in conjunction with the first aspect, the substrate (2) is a nitride semiconductor substrate. The first surface (21) of the substrate (2) is a crystallographic plane extending along a c-axis. The second direction D2 is defined along the c-axis of the substrate (2). Each of the first compound semiconductor portion (31) and the second compound semiconductor portion (32) is a nitride semiconductor. This allows the semiconductor device (1) to reduce the on-state resistance thereof while increasing its breakdown voltage.

In a semiconductor device (1) according to a third aspect, which may be implemented in conjunction with the first or second aspect, the gate layer 7 is a p-type semiconductor layer. Thus, in this semiconductor device (1), the gate layer 7 and the gate electrode 6 are able to make an ohmic contact with each other.

In a semiconductor device (1) according to a fourth aspect, which may be implemented in conjunction with any one of the first to third aspects, the semiconductor portion (3) includes a plurality of the heterojunctions (35). This allows the semiconductor device (1) to reduce the ON-state resistance thereof while increasing its breakdown voltage.

In a semiconductor device (1) according to a fifth aspect, which may be implemented in conjunction with the fourth aspect, the plurality of the heterojunctions (35) extend parallel to each other. This allows the semiconductor device (1) to further reduce the on-state resistance thereof.

### Reference Signs List

- 1: Semiconductor Device
- 2: Substrate
- 21: First Surface
- 22: Second Surface
- 3: Semiconductor Portion
- 30: Double Heterostructure
- 31: First Compound Semiconductor Portion
- 32: Second Compound Semiconductor Portion
- 33: Third Compound Semiconductor Portion
- 35: Heterojunction (First Heterojunction)
- 4: First Electrode
- 5: Second Electrode
- 6: Gate Electrode
- 7: Gate Layer
- 8: Depletion Layer
- D1: First Direction
- D2: Second Direction

## Claims

1. A semiconductor device comprising:
a substrate having electrical conductivity and having a first surface and a second surface, the first surface and the second surface being located opposite from each other in a first direction, the first direction defining a thickness direction for the substrate;
a semiconductor portion provided on the first surface of the substrate and including a heterojunction defining a junction between a first compound semiconductor portion and a second compound semiconductor portion having a greater bandgap than the first compound semiconductor portion, the heterojunction intersecting with a second direction defined along the first surface of the substrate;
a first electrode arranged opposite from the substrate with respect to the semiconductor portion, the first electrode being electrically connected to the heterojunction;
a second electrode arranged on the second surface of the substrate and electrically connected to the substrate;
a gate electrode intersecting with the second direction between the first electrode and the second electrode and facing the second compound semiconductor portion: and
a gate layer interposed in the second direction between the gate electrode and the second compound semiconductor portion and forming a depletion layer in the second compound semiconductor portion and the first compound semiconductor portion.

2. The semiconductor device of claim 1, wherein
the substrate is a nitride semiconductor substrate,
the first surface of the substrate is a crystallographic plane extending along a c-axis,
the second direction is defined along the c-axis, and
each of the first compound semiconductor portion and the second compound semiconductor portion is a nitride semiconductor.

3. The semiconductor device of claim 1 or 2, wherein
the gate layer is a p-type semiconductor layer.

4. The semiconductor device of any one of claims 1 to 3, wherein
the semiconductor portion includes a plurality of the heterojunctions.

5. The semiconductor device of claim 4, wherein
the plurality of the heterojunctions extend parallel to each other.
